(19) Europäisches Patentamt
European Patent Office
Office européen des brevets

(11) **EP 1 110 315 B1**

(12) **EUROPEAN PATENT SPECIFICATION**

(45) Date of publication and mention of the grant of the patent:
**26.03.2008  Bulletin 2008/13**

(21) Application number: **00936903.4**

(22) Date of filing: **21.06.2000**

(51) Int Cl.:
***H03H 21/00*** *(2006.01)*

(86) International application number:
**PCT/EP2000/005711**

(87) International publication number:
**WO 2001/001571 (04.01.2001 Gazette 2001/01)**

(54) **ACOUSTIC ECHO AND NOISE CANCELLATION**

AKUSTISCHE ECHO- UND RAUSCHKOMPENSATION

SUPPRESSION D'ECHO ET DE BRUIT ACOUSTIQUES

(84) Designated Contracting States:
**DE ES FR GB IT**

(30) Priority:  **24.06.1999  EP 99202026**
**30.03.2000  EP 00201142**

(43) Date of publication of application:
**27.06.2001   Bulletin 2001/26**

(73) Proprietor: **Koninklijke Philips Electronics N.V.**
**5621 BA  Eindhoven (NL)**

(72) Inventors:
 • **EGELMEERS, Gerardus, P., M.**
**NL-5656 AA Eindhoven (NL)**
 • **JANSE, Cornelis, P.**
**NL-5656 AA Eindhoven (NL)**

(74) Representative: **Schoenmaker, Maarten**
**Philips**
**Intellectual Property & Standards**
**P.O. Box 220**
**5600 AE Eindhoven (NL)**

(56) References cited:
**US-A- 4 355 368**

 • **YUAN-HWANG CHEN ET AL: "FREQUENCY-DOMAIN IMPLEMENTATION OF GRIFFITHS-JIM ADAPTIVE BEAMFORMER" JOURNAL OF THE ACOUSTICAL SOCIETY OF AMERICA, US, AMERICAN INSTITUTE OF PHYSICS. NEW YORK, vol. 91, no. 6, 1 June 1992 (1992-06-01), pages 3354-3366, XP000290213 ISSN: 0001-4966**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

**Description**

The invention relates to a filter as described in the preamble of claim 1.

The invention further relates to a signal processing device comprising such a filter.

The invention further relates to a teleconferencing system.

Further the invention relates to a voice controlled electronic device.

The invention also relates to a noise cancellation system.

The invention further relates to a method as described in the preamble of claim 12.

Recent developments in audio and video systems require the use of multiple channel processing and reproduction with acoustic echo cancellers (AEC) and noise cancellers.

For example in mini group video conferencing systems multiple channel transmission leads to a better "localization" of the diverse people in the room. This enhances the intelligibility and naturalness of the speech.

Further multiple channel echo cancellation is needed in voice controlled stereo audio and video equipment such as television receivers, radio receivers, CD players etc.. A multiple channel AEC can in general not be created by simple combination of multiple single channel AEC's.

From the United States patent US-A 5,828,756 a method and apparatus are known of a stereophonic communication system such as a teleconferencing system, which involves selectively reducing the correlation between the individual channel signals of the stereophonic system. Herein non-linearities are added to the input signals to reduce the correlation. However by adding these non-linearities audible artifacts in the output signals are introduced. These non-linearities can (sometimes) be accepted in teleconferencing systems but are certainly not acceptable in other applications such as supplying music etc.

The article "Frequency Domain Implementation of Griffiths-Jim Adaptive Beamformer" by Yuan-Hwang Chen et al, Journal of the Acoustical Society of America, USA, American Institute of Physics, New York, vol. 91, no.6, 01.06.1992, pages 3354-3366 discloses an algorithm for determining coefficients for an adaptive beamformer.

It is, *inter alia,* an object of the invention to provide a filter, which overcomes the objections of the prior art. To this end a first aspect of the invention provides a filter as claimed in claim 1.

Herewith the performance of the adaptive filters is improved without a huge increase in computational complexity.

A second aspect of the invention provides a signal-processing device as claimed in claim 6.

A third aspect of the invention provides a teleconferencing system as claimed in claim 9.

A fourth aspect of the invention provides a voice controlled electronic device as claimed in claim 10.

A fifth aspect of the invention provides a noise cancellation system as claimed in claim 11.

A sixth aspect of the invention provides a method as claimed in claim 12.

An embodiment of the invention comprises the features of claim 2.

The invention and additional features, which may be optionally used to implement the invention to advantage will be apparent from and elucidated with references to the examples described below, hereinafter and shown in the figures. Herein shows:

Figure 1 schematically the multiple input adaptive FIR filter, according to the invention,

Figure 2 schematically the calculation of the output of the FIR filter, according to the invention,

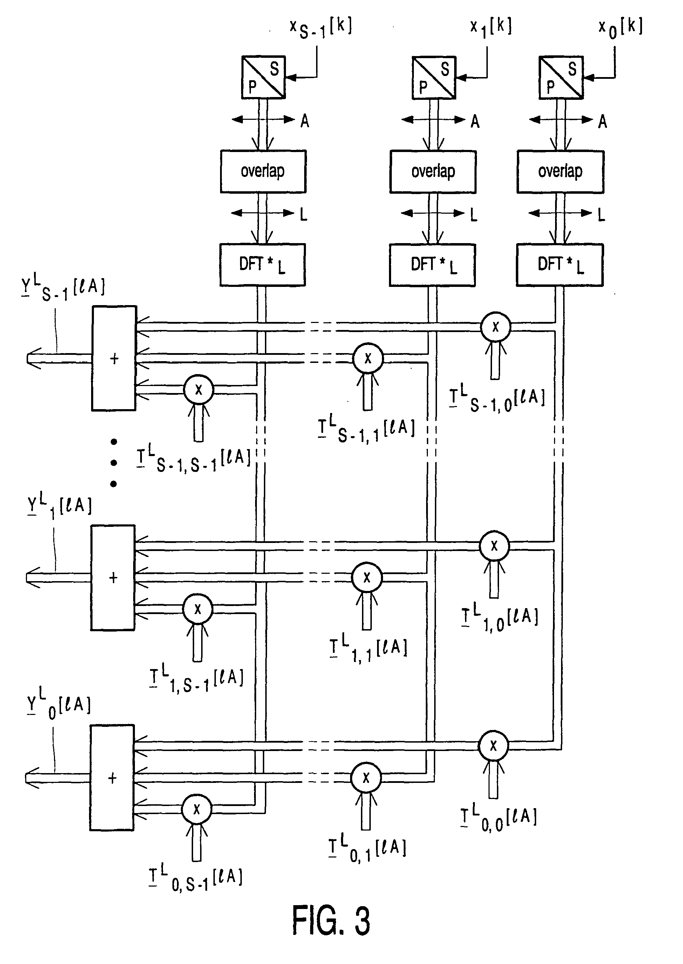

Figure 3 schematically the calculation of Y in the Multiple Input Partitioned Frequency Domain adaptive filter, according to the invention for the case with direct inverse power estimation,

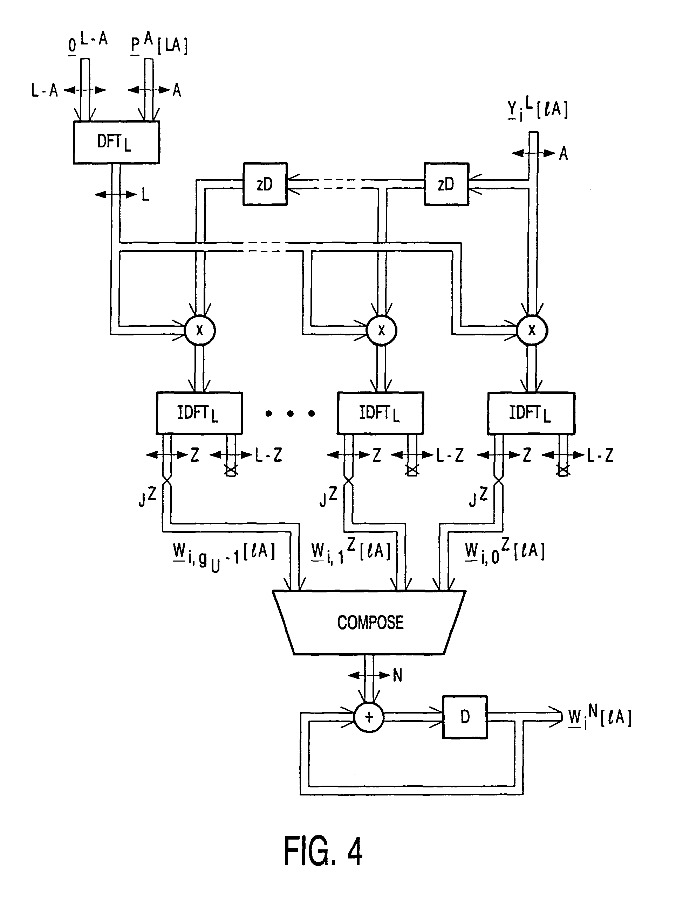

Figure 4 schematically the calculation of the coefficient vectors $\underline{w}_i$ according to the invention,

Figure 5 a schematic example of a stereo echo cancellation in a teleconferencing system according to the invention,

Figure 6 a more detailed schematic example of a teleconferencing system according to the invention,

Figure 7 a schematic example of a voice controlled device according to the invention, and

Figure 8 a schematic example of a noise canceller according to the invention.

In the description the equations, matrices, etc are shown as described below. Signals are denoted by lower case characters, constants by upper case. Underlining is used for vectors, lower case for time domain, and upper case for frequency domain. Matrices are denoted by bold face upper case, like **I.** The dimension is put in superscript (e.g. the $B \times Q$ matrix $\boldsymbol{X}$ is given by $X^{B,Q}$, for a square matrix the second dimension is omitted). Diagonal matrix are denoted by a double underline, like $\underline{\underline{\boldsymbol{P}}}$, with its diagonal denoted as $\underline{P} = \text{diag } \{\underline{\underline{\boldsymbol{P}}}\}$. A subscript $i$, like $\underline{w}_i$, denotes the $i$'th version. The $k$'th element of $\underline{w}$ is given by $(\underline{w})_k$. Finally, appending $[k]$ denotes the time index, $(.)^t$ denotes the transpose, $(.)^*$ the complex conjugate and $(.)^h$ the Hermita in transpose (complex conjugate transpose).

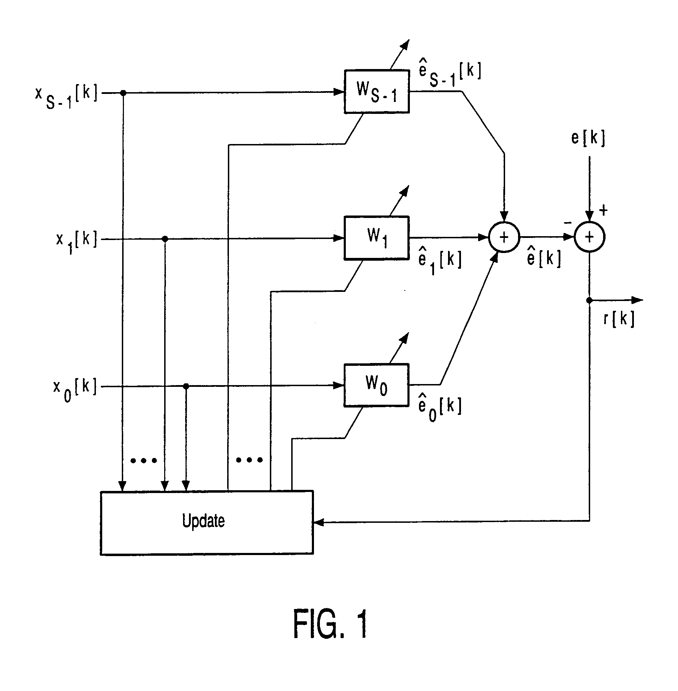

A general multiple input adaptive FIR filter, depicted in figure 1, uses the S signals $x_0[k]$ until $x_{s-1}[k]$ to remove unwanted components correlated with these signals in the signal $e[k]$. The signals $x_0[k]$ until $x_{s-1}[k]$ are input to S FIR-filters $W_0$ until $W_{s-1}$, with outputs $\hat{e}_0[k]$ until $\hat{e}_{s-1}[k]$. The goal of the update algorithm is to adapt the coefficients of the FIR filters in such a way that the correlation between $r[k]$ and the input signals $x_0[k]$ and $x_{S-1}[k]$ is removed.

For $S > \alpha \geq 0$ the FIR filter $W_a$ performs the convolution of the signal $x_a[k]$ and the coefficients $w_{a,0}[k]$ ... $w_{a,N-1}[k]$ of that filter. The output signal $\hat{e}_a[k]$ of such a filter can be described as follows

$$\hat{e}_a[k] = \sum_{i=0}^{N-1} x_a[k-i] \cdot w_{a,i}[k] = \left(\underline{x}_a^N[k]\right)^t \cdot \underline{w}_a^N[k] \tag{1}$$

with for $S > a \geq 0$

$$\underline{x}_a^N[k] = \begin{pmatrix} x_a[k-N+1] \\ \vdots \\ x_a[k-1] \\ x_a[k] \end{pmatrix} \tag{2}$$

$$\underline{w}_a^N[k] = \begin{pmatrix} w_{a,N-1}[k] \\ \vdots \\ w_{a,1}[k] \\ w_{a,0}[k] \end{pmatrix}. \tag{3}$$

The output of the multiple input adaptive filter is given by

$$r[k] = e[k] - \sum_{a=0}^{S-1} \hat{e}_a[k]. \tag{4}$$

These filter parts of the separate (adaptive) filters $W_0$ until $W_{S-1}$ can be implemented efficiently in frequency domain with help of partitioning, block processing and Discrete Fourier Transforms (DFTs). A reduction in computational complexity is obtained since the convolutions per sample in the time domain transform to elementwise multiplications per block in the frequency domain. We use block processing with block length B and DFTs of length M, with $M \geq N + B - 1$. The transformation of the input signals can be described for $S > a \geq 0$ by

$$\underline{X}_a^M[kB] = \mathbf{F}^M \cdot \begin{pmatrix} x_a[kB-M+1] \\ \vdots \\ x_a[kB] \end{pmatrix}, \tag{5}$$

where $F^M$ is the M x M Fourier matrix. The (a,b)'th element (for $0 \leq a < M, 0 \leq b < M$) of the Fourier matrix is given by

$$\left(\mathbf{F}^M\right)_{a,b} = e\frac{-j2\pi ab}{M} \tag{6}$$

where $j = \sqrt{-1}$.

The filter can then be computed in the frequency domain, by

$$\underline{\hat{e}}[kB] = \left(\mathbf{0} \quad \mathbf{I}^B\right)\sum_{a=0}^{S-1}\underline{\underline{\mathbf{X}}}_a^M[kB]\underline{W}_a^M[kB] = \begin{pmatrix} \hat{e}[kB - B + 1] \\ \vdots \\ \hat{e}[kB] \end{pmatrix}. \tag{7}$$

Note that the frequency domain filter coefficients are related to the time domain coefficients, for all S > $a \geq 0$ this can be denoted by

$$\underline{W}_a^M[l] = \mathbf{F}^M \cdot \begin{pmatrix} w_a,0[l] \\ w_a,1[l] \\ \vdots \\ w_{a,N-1}[l] \\ \underline{0} \end{pmatrix}. \tag{8}$$

To obtain an efficient implementation, the block length B must be chosen in the same order as the filter length N, which results in a large processing delay.

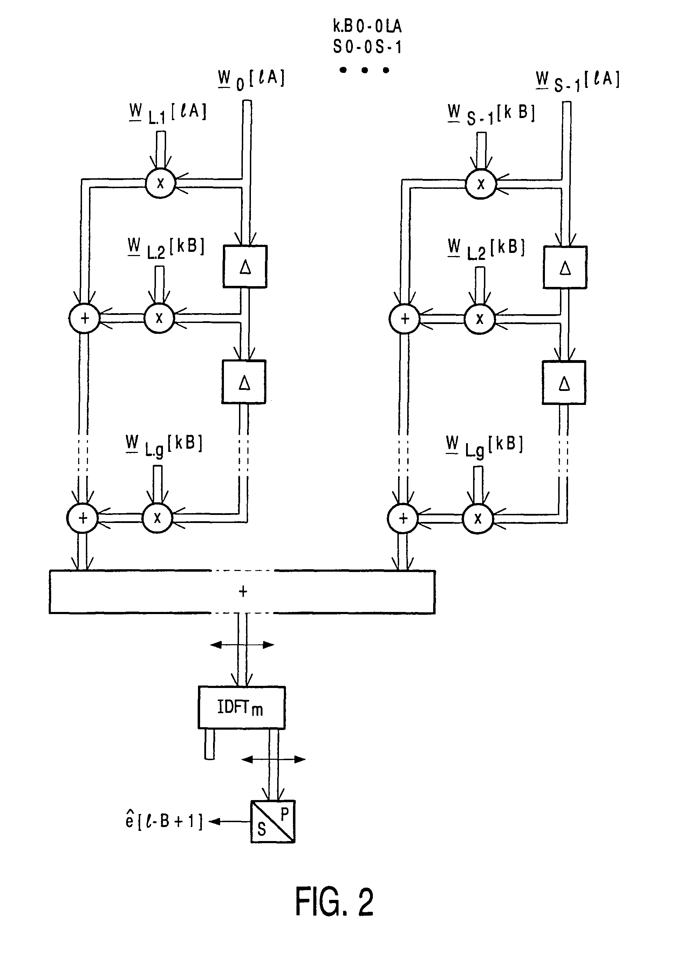

To reduce the processing delay, the filter can be partitioned into smaller pieces of length B and with $g = \lceil N/B \rceil$ we get the implementation of figure 2, that can be described by

$$\underline{\hat{e}}[kB] = \left(\mathbf{0} \quad \mathbf{I}^B\right) \cdot \sum_{a=0}^{S-1} \sum_{i=1}^{g} \underline{\underline{\mathbf{X}}}_a^M[(k-i)B]\underline{W}_{a,i}^M[kB] \tag{9}$$

with

$$\underline{W}_{a,i}^M[l] = \mathbf{F}^M \cdot \begin{pmatrix} w_{a,iB}[l] \\ w_{a,iB+1}[l] \\ \vdots \\ w_{a,iB+B-1}[l] \\ \underline{0} \end{pmatrix}. $$

For the update part of the filter one can use S separate update algorithms to improve convergence behavior; the input signals can be decorrelated separately in the time domain by using RLS like algorithms, leading to a huge computational complexity. Complexity reduction can be obtained by implementation in the frequency domain with (partitioned) Block Frequency Domain Adaptive Filters as described in G.P.M. Egelmeers, Real time realization of large adaptive filters, Ph.D. thesis, Eindhoven University of Technology, Eindhoven (The Netherlands), Nov. 1995. When there is correlation between the input signals of the filters this might still lead to very bad convergence behavior, due to the non-uniqueness problem.

In this application it is proposed to use a partitioned algorithm in the frequency domain that reduces the effect of the crosscorrelation between the input signals on the algorithm's convergence behavior. To reduce complexity block processing with block length A to compute the sum of A consecutive updates with each iteration is used. For $S > a \geq 0$ the coefficient vectors $\underline{w}_a^N[lA]$ are partitioned into $g_u$ parts of length Z with $g_u = [N/Z]$ such that for $S > j \geq 0$

$$\underline{w}_j^N[lA] = \begin{pmatrix} \underline{w}_{j,gu-1}^Z[lA] \\ \vdots \\ \underline{w}_{j,1}^Z[lA] \\ \underline{w}_{j,0}^Z[lA] \end{pmatrix}$$

with for $S > j \geq 0$ and $g_u > i \geq 0$

$$\underline{w}_{j,i}^Z[lA] = \begin{pmatrix} w_{j,iZ+Z-1}[lA] \\ \vdots \\ w_{j,iZ+1}[lA] \\ w_{j,iZ}[lA] \end{pmatrix}.$$

A Fourier transform length $L$ is used with $L \geq Z + A\text{-}1$, we define the input signal Fourier transforms for $S > a \geq 0$ as

$$\underline{X}_a^L[lA] = \mathbf{F}^L \cdot \underline{x}_a^L[lA]$$

$$= \mathbf{F}^L \cdot \begin{pmatrix} x_a[lA - L + 1] \\ \vdots \\ x_a[lA - 1] \\ x_a[lA] \end{pmatrix}.$$

The diagonal matrices $\underline{\underline{X}}_a^L[lA]$ contain the vector $\underline{X}_a^L[lA]$ as main diagonal, so for $S > a \geq 0$

$$\underline{\underline{X}}_a^L[lA] = diag\{\underline{X}_a^L[lA]\}.$$

An overlap-save method is used to compute the correlation involved in the adaptation process in the frequency domain, the frequency domain transform of the residual signal vector equals

$$\underline{R}^L[lA] = \mathbf{F}^L \cdot \begin{pmatrix} \underline{0}^{L-A} \\ \underline{r}^A[lA] \end{pmatrix}.$$

The set of update equations for the filter coefficients in the MFDAF (Multiple Input Frequency Domain Adaptive Filter) algorithm can now be defined for $g_u > i \geq 0$ by

$$\begin{pmatrix} \underline{w}^Z_{S-1,i}[(l+1)A] \\ \vdots \\ \underline{w}^Z_{1,i}[(l+1)A] \\ \underline{w}^Z_{0,i}[(l+1)A] \end{pmatrix} = \begin{pmatrix} \underline{w}^Z_{S-1,i}[lA] \\ \vdots \\ \underline{w}^Z_{1,i}[lA] \\ \underline{w}^Z_{0,i}[lA] \end{pmatrix}$$

$$+ \, \boldsymbol{G}^{S.Z.S.L} \cdot \begin{pmatrix} \left(\underline{\underline{Y}}^L_{S-1}[lA-iZ]\right)* \\ \vdots \\ \left(\underline{\underline{Y}}^L_{1}[lA-iZ]\right)* \\ \left(\underline{\underline{Y}}^L_{0}[lA-iZ]\right)* \end{pmatrix} \cdot \underline{R}^L[lA]$$

with

$$\begin{pmatrix} \left(\underline{\underline{Y}}^L_{S-1}[lA]\right)* \\ \vdots \\ \left(\underline{\underline{Y}}^L_{1}[lA]\right)* \\ \left(\underline{\underline{Y}}^L_{0}[lA]\right)* \end{pmatrix} = 2\alpha \left(\mathbf{P}^{S.L}[lA]\right)^{-1} \cdot \begin{pmatrix} \left(\underline{\underline{X}}^L_{S-1}[lA]\right)* \\ \vdots \\ \left(\underline{\underline{X}}^L_{1}[lA]\right)* \\ \left(\underline{\underline{X}}^L_{0}[lA]\right)* \end{pmatrix}$$

and the transformation matrix $\boldsymbol{G}^{S.Z.S.L}$ is given by

$$G^{S.Z.S.L} = \begin{pmatrix} \mathbf{G}^{Z,L} & \mathbf{0}^{Z,L} & \cdots & \mathbf{0}^{Z,L} \\ \mathbf{0}^{Z,L} & \ddots & \ddots & \vdots \\ \vdots & \ddots & \ddots & \mathbf{0}^{Z,L} \\ \mathbf{0}^{Z,L} & \cdots & \mathbf{0}^{Z,L} & \mathbf{G}^{Z,L} \end{pmatrix}$$

with

$$\mathbf{G}^{Z,L} = \begin{pmatrix} \mathbf{J}^Z & \mathbf{0}^{Z,L-Z} \end{pmatrix} \begin{pmatrix} \mathbf{F}^L \end{pmatrix}^{-1}.$$

The input channel's power matrix $\mathbf{P}^{S.L}[lA]$ is defined by

$$\mathbf{P}^{S.L}[lA] = \frac{1}{L}\left\{\left(\mathbf{X}^{S.L,L}[lA]\right)^* \cdot \left(\mathbf{X}^{S.L,L}[lA]\right)^t\right\}$$

$$= \frac{1}{L}\begin{pmatrix} \varepsilon\left\{\left(\underline{\mathbf{X}}^L_{S-1}[lA]\right)^* \underline{\mathbf{X}}^L_{S-1}[lA]\right\} & \cdots & \varepsilon\left\{\left(\underline{\mathbf{X}}^L_{S-1}[lA]\right)^* \underline{\mathbf{X}}^L_0[lA]\right\} \\ \vdots & \ddots & \vdots \\ \varepsilon\left\{\left(\underline{\mathbf{X}}^L_0[lA]\right)^* \underline{\mathbf{X}}^L_{S-1}[lA]\right\} & \cdots & \varepsilon\left\{\left(\underline{\mathbf{X}}^L_0[lA]\right)^* \underline{\mathbf{X}}^L_0[lA]\right\} \end{pmatrix}$$

where

$$\mathbf{X}^{S.L,L}[lA] = \begin{pmatrix} \underline{\mathbf{X}}^L_{S-1}[lA] \\ \vdots \\ \underline{\mathbf{X}}^L_1[lA] \\ \underline{\mathbf{X}}^L_0[lA] \end{pmatrix}.$$

The expectation operator $\varepsilon\{\}$ of the above equation has to be replaced by an estimation routine.
The power matrix $\mathbf{P}^{S.L}[lA]$ can be estimated by

$$\mathbf{P}^{S.L}[lA] = (1-\gamma)\mathbf{P}^{S.L}[(l-1)A] + \frac{\gamma}{r}\left(\mathbf{X}^{S.L,L}[lA]\right)^* \cdot (\mathbf{X}^{S.L,L}[lA])^t \tag{10}$$

To reduce the number of multiplications, the stepsize parameter $\alpha$ of equation is incorporated in the above power estimation routine by defining

$$\mathbf{P}_\alpha^{S.L}[lA] = \frac{1}{2\alpha}\mathbf{P}^{S.L}[lA] \qquad\qquad (11)$$

so

$$2\alpha\left(\mathbf{P}^{SL}[lA]\right)^{-1} = \left(\mathbf{P}_\alpha^{SL}[lA]\right)^{-1}. \qquad\qquad (12)$$

Estimation of the power matrix $\mathbf{P}_\alpha^{S.L}[lA]$ ' $[lA]$ can then be done by

$$\mathbf{P}_\alpha^{S.L}[lA] = (1-\gamma)\cdot\mathbf{P}_\alpha^{S.L}[(l-1)A] + \frac{\gamma}{2\alpha L}\cdot\left(\mathbf{X}^{S.L,L}[lA]\right)^* \cdot \left(\mathbf{X}^{S.L,L}[lA]\right)^t. \qquad\qquad (13)$$

Direct application of this algorithm leads to stability problems. When the input signal power in a certain frequency bin is very small, the power in that bin will decrease to a (very) small value. The inverse of the matrix will then have large values and will be inaccurate (due to numerical and estimation errors). In the ideal case, the eigenvalues of the power matrix estimate cancel the eigenvalues of the input signal power matrix. Due to estimation errors this goal is only approximated, and the mismatch introduces a deviation from the ideal convergence behavior and might even lead to instability. Especially when some of the eigenvalues of the estimate of the inverse power matrix get large, and do not (exactly) cancel a (small) eigenvalue of the input signal power matrix, instability might occur. A lower limit to the eigenvalues of the estimate of the power matrix can solve this problem. In the single channel case (or when we forget the cross-terms) we can solve this problem by applying a lower limit to the lower values. We can do this because the eigenvalues of a diagonal matrix are equal to the elements of the diagonal, so we actually limit the eigenvalues. In the multiple channel case we also have to limit the eigenvalues to assure stability, but these no longer equal the elements on the diagonal.

We know however that all eigenvalues of the power matrix are positive. We can now create a lower limit on the eigenvalues by shifting them by the suggested minimum. We know that for all eigenvalues $\lambda$ of a matrix A, the determinant of $\mathbf{A}+(P_{min}-\lambda')\cdot\mathbf{I}$ must be zero. So for all $\lambda'$, eigenvalue of $\mathbf{A} + P_{min}\cdot\mathbf{I}$, there must be a $\lambda$, eigenvalue of $\mathbf{A}$, such that $\lambda' = \lambda + P_{min}$ (and the other way around). This means that by adding a constant $P_{min}$ to the main diagonal of a matrix, all eigenvalues of that matrix are shifted by $P_{mmin}\cdot$). So we define:

$$\mathbf{P}_{\alpha,\lim}^{S.L}[lA] = \mathbf{P}_\alpha^{S.L}[lA] + \frac{P_{min}}{2\alpha}\cdot\mathbf{I}^{S.L}$$

which results in

$$\mathbf{P}_{\alpha,\lim}^{S.L}[lA] = (1-\gamma)\cdot\mathbf{P}_{\alpha,\lim}^{S.L}[(l-1)A] + \gamma\cdot\left(\frac{1}{2\alpha L}\cdot\left(\mathbf{X}^{S.L,L}[lA]\right)^* \cdot \left(\mathbf{X}^{S.L,L}[lA]\right)^t + \frac{P_{min}}{2\alpha}\cdot\mathbf{I}^{S.L}\right).$$

The effect of this shifting of the eigenvalues on the (theoretical ideal) convergence behaviour of the algorithm will be very small, and in practice the algorithm is much more stable.

Although $\mathbf{P}_{\alpha,\lim}^{S.L}[lA]$ is a sparse matrix, computing its inverse would still require L inversions of $SxS$ matrices, which takes in the order of $L\cdot S^3$ operations. As we however do not need the inverse itself, but only its matrix-vector product with the input signals we can also look at it as solving the system

$$\mathbf{P}_{\alpha,\lim}^{S.L}[lA] \begin{pmatrix} \underline{\underline{\mathbf{Y}}}_{S-1}^{L}[lA]^* \\ \vdots \\ \underline{\underline{\mathbf{Y}}}_{1}^{L}[lA]^* \\ \underline{\underline{\mathbf{Y}}}_{0}^{L}[lA]^* \end{pmatrix} = \begin{pmatrix} \underline{\underline{\mathbf{X}}}_{S-1}^{L}[lA]^* \\ \vdots \\ \underline{\underline{\mathbf{X}}}_{1}^{L}[lA]^* \\ \underline{\underline{\mathbf{X}}}_{0}^{L}[lA]^* \end{pmatrix}.$$

which requires in the order of $L \cdot S^2$ operations. Another option is to estimate the inverse of $P^{S.L}[lA]$ directly, which also results in a number of operations proportional to $L \cdot S^2$. However, also in this case we have to limit the eigenvalues to assure stability.

A simple algorithm is given by:

$$\left(\mathbf{P}^{S \cdot L}[lA]\right)^{-1} = (1+\gamma) \cdot \left(\mathbf{P}^{S \cdot L}[(l-1)A]\right)^{-1} - \frac{\gamma}{L} \mathbf{Q}^{S \cdot L,L}[lA] \cdot \left(\mathbf{Q}^{S \cdot L,L}[lA]\right)^{h}$$

with

$$\mathbf{Q}^{S \cdot L,L}[lA] = \left(\mathbf{P}^{S \cdot L}[lA]\right)^{-1} \cdot \begin{pmatrix} \underline{\underline{\mathbf{X}}}_{S-1}^{L}[lA]^* \\ \vdots \\ \underline{\underline{\mathbf{X}}}_{1}^{L}[lA]^* \\ \underline{\underline{\mathbf{X}}}_{0}^{L}[lA]^* \end{pmatrix} = \left(\mathbf{P}^{S \cdot L}[lA]\right)^{-1} \cdot \left( \mathbf{X}^{S \cdot L,L}[lA] \right)^*. \tag{14}$$

We can incorporate $\alpha$, which results in

$$\left(\mathbf{P}_{\alpha}^{S \cdot L}[lA]\right)^{-1} = (1+\gamma) \cdot \left(\mathbf{P}_{\alpha}^{S \cdot L}[(l-1)A]\right)^{-1} - \frac{\gamma}{2\alpha L} \mathbf{Q}^{S \cdot L,L}[lA] \cdot \left(\mathbf{Q}^{S \cdot L,L}[lA]\right)^{h}.$$

The above algorithm does not guarantee a matrix $(P_{\alpha}^{S.L}[lA])^{-1}$ with positive eigenvalues, and therefore introduces a lot of stability problems. In the single channel case we are able to stabilize the algorithm by using a lower limit on the estimate, which automatically results in positive eigenvalues because the matrix is diagonal, but that is not possible in the multiple channel case.

**Positive eigenvalues**

An exact transformation of an algorithm for estimating $\mathbf{P}_{\alpha}^{S \cdot L}[lA]$ with positive eigenvalues will lead to an estimation algorithm for the inverse with positive eigenvalues. This can be done by using the matrix inversion lemma. When there is matrix A such that

$$A = B + C \cdot D \cdot E \tag{15}$$

then the inverse matrix $(\mathbf{A})^{-1}$ of A can be expressed by

$$(\mathbf{A})^{-1} = (\mathbf{B})^{-1} - (\mathbf{B})^{-1} \cdot \mathbf{C} \cdot ((\mathbf{D})^{-1} + \mathbf{E} \cdot (\mathbf{B})^{-1} \cdot \mathbf{C})^{-1} \cdot \mathbf{E} \cdot (\mathbf{B})^{-1} \cdot \tag{16}$$

By choosing

$$
\begin{aligned}
\mathbf{A} &= \mathbf{P}\,_{\alpha}^{S \cdot L}\left[lA\right] \\
\mathbf{B} &= (1-\gamma) \cdot \mathbf{P}_{\alpha}^{S \cdot L}\left[(l-1)A\right] \\
\mathbf{C} &= (\mathbf{X}^{S \cdot L, L}\left[lA\right])^{*} \\
\mathbf{D} &= \frac{\gamma}{2\alpha L} \cdot \mathbf{I}^{L} \\
\mathbf{E} &= \mathbf{C}^{h} = (\mathbf{X}^{S \cdot L, L}\left[lA\right])^{t}
\end{aligned}
\tag{17}
$$

and

$$
\begin{aligned}
\mathbf{Q} &= (\mathbf{B})^{-1} \cdot \mathbf{C} \\
&= \mathbf{E} \cdot (\mathbf{B})^{-1} \\
&= \frac{1}{1-\gamma} \cdot (\mathbf{P}\,_{\alpha}^{S \cdot L}\left[(l-1)A\right])^{-1} \cdot (\mathbf{X}^{S \cdot L, L}\left[lA\right])^{*}
\end{aligned}
\tag{18}
$$

we obtain by using equation (14)

$$(\mathbf{P}_{\alpha}^{S \cdot L}\left[lA\right])^{-1} = \frac{1}{1-\gamma}\mathbf{P}_{\alpha}^{S \cdot L}\left[(l-1)A\right]^{-1} - \mathbf{Q}^{S \cdot L, L}\left[lA\right] \cdot (\underline{\mathbf{D}}^{L}\left[lA\right])^{-1} \cdot (\mathbf{Q}^{S \cdot L, L}\left[lA\right])^{h} \tag{19}$$

with

$$\underline{\mathbf{D}}^{L}\left[lA\right] = \frac{2\alpha L}{\gamma}\mathbf{I}^{L} + (\mathbf{X}^{S \cdot L, L}\left[lA\right])^{t} \cdot \mathbf{Q}^{S \cdot L, L}\left[lA\right] \cdot \tag{20}$$

Algorithm (19) involves no matrix inversion, and only $L / 2 + 1$ divisions, as the matrix $\underline{\mathbf{D}}^{L}$ [$lA$] of equation (20) is a real valued diagonal matrix.

**Limits on the eigenvalues**

An operation on the inverse power matrix that is equivalent to adding a constant to the diagonal of the (non-inverse) power matrix would solve the problem. Adding a full $(S \cdot L) \times (S \cdot L)$ identity matrix and trying to find an equivalent operation on the inverse power matrix with the matrix inversion lemma results in an algorithm that requires the matrix inversion we would like to avoid, so we try

$$\mathbf{P}_{\alpha,\lim}^{S \cdot L}[lA] = (1-\gamma) \cdot \mathbf{P}_{\alpha,\lim}^{S \cdot L}[(l-1)A] + \frac{\gamma}{2\alpha L} \cdot (\mathbf{X}_{\lim}^{S \cdot L, L}[lA])^* \cdot (\mathbf{X}_{\lim}^{S \cdot L, L}[lA])^t \tag{21}$$

with

$$(\mathbf{X}_{\lim}^{S \cdot L, L}[lA])^* \cdot (\mathbf{X}_{\lim}^{S \cdot L, L}[lA])^t = (\mathbf{X}^{S \cdot L, L}[lA])^* \cdot (\mathbf{X}^{S \cdot L, L}[lA])^t + P_{\min} \cdot 2\alpha L \cdot \mathbf{I}^{S \cdot L} \cdot \tag{22}$$

As the matrix I has rank $S.L$ and the product matrices $(\mathbf{X}_{\lim}^{S \cdot L, L}[lA])^* \cdot (\mathbf{X}_{\lim}^{S \cdot L, L}[lA])^t$ and $(\mathbf{X}^{S \cdot L, L}[lA])^* \cdot (\mathbf{X}^{S \cdot L, L}[lA])^t$ both have a rank of (at most) L this is not possible for S>1. As we need the average of $(\mathbf{X}^{S \cdot L, L}[lA])^* \cdot (\mathbf{X}^{S \cdot L, L}[lA])^t$, we can find a solution by taking the average over S consecutive updates. We will try to find $\mathbf{X}_{\lim}^{S \cdot L, L}[lA]$ such that

$$\begin{aligned}
&\varepsilon\left\{\sum_{a=0}^{S-1}(\mathbf{X}_{\lim}^{S \cdot L, L}[(l+a)A])^* \cdot (\mathbf{X}_{\lim}^{S \cdot L, L}[(l+a)A])^t\right\} \\
&= \varepsilon\left\{\sum_{a=0}^{S-1}(\mathbf{X}^{S \cdot L, L}[(l+a)A])^* \cdot (\mathbf{X}^{S \cdot L, L}[(l+a)A])^t\right\} + P_{\min} \cdot 2\alpha LS \cdot \mathbf{I}^{S \cdot L}
\end{aligned} \tag{23}$$

with for $i = l \bmod S$

$$\begin{aligned}
\mathbf{X}_{\lim}^{S \cdot L, L}[lA] &= \begin{pmatrix} \underline{\underline{\mathbf{X}}}_{S-1}^{L}[lA] \\ \vdots \\ \underline{\underline{\mathbf{X}}}_{1}^{L}[lA] \\ \underline{\underline{\mathbf{X}}}_{0}^{L}[lA] \end{pmatrix} + \begin{pmatrix} u_{S-1,i} \cdot \mathbf{I}^{L} \\ \vdots \\ u_{1,i} \cdot \mathbf{I}^{L} \\ u_{0,i} \cdot \mathbf{I}^{L} \end{pmatrix} \\
&= \mathbf{X}^{S \cdot L, L}[lA] + \begin{pmatrix} u_{S-1,i} \cdot \mathbf{I}^{L} \\ \vdots \\ u_{1,i} \cdot \mathbf{I}^{L} \\ u_{0,i} \cdot \mathbf{I}^{L} \end{pmatrix} \cdot
\end{aligned} \tag{24}$$

with

$$\mathbf{U}^S = \begin{pmatrix} u_{S-1,S-1} & \cdots & u_{S-1,1} & u_{S-1,0} \\ \vdots & & \vdots & \vdots \\ u_{1,S-1} & \cdots & u_{1,1} & u_{1,0} \\ u_{0,S-1} & \cdots & u_{0,1} & u_{0,0} \end{pmatrix}. \tag{25}$$

For $S=1$ we get

$$\mathbf{U}^1 = \sqrt{P_{min} \cdot 2\alpha L} \tag{26}$$

For S > 1 there are an infinite number of solutions. If we try to keep the maximum distorsion (the largest matrix element) as small as possible, we have to choose for all $S > j \geq 0$ and

$$S > i \geq 0$$

$$u_{j,i} = \pm\sqrt{P_{min} \cdot 2\alpha L} \cdot \tag{27}$$

If there is a real symmetric matrix $U^L$ for $S=L$ then a real symmetric matrix $\mathbf{U}^{2L}$ for $S = 2L$ is given by

$$\mathbf{U}^{2L} = \begin{pmatrix} \mathbf{U}^L & \mathbf{U}^L \\ \mathbf{U}^L & -\mathbf{U}^L \end{pmatrix}. \tag{28}$$

Using the above equation we can construct all $\mathbf{U}^{2^i}$ with $i > 0$. If $S + 1$ is not a power of two, then we will use the matrix $\mathbf{U}^{2^i}$ where $2^i > S + 1 > 2^{i-1}$, and use the last S rows. In table 1 the power matrix estimation algorithm using a direct inverse estimation with limits on the eigenvalues is summarized.

Table 1: *Direct inverse power update with limits.*

**Initialization**

1. $S_u = 2^{\lceil \log_2 S+1 \rceil}$

$$\mathbf{U}^1 = \sqrt{P_{min}} \cdot 2\alpha L$$

*for i = 1 to* $\log_2 (S_u) do$
*2. begin*

$$\mathbf{U}^{2^i} = \begin{pmatrix} \mathbf{U}^{2^{i-1}} & \mathbf{U}^{2^{i-1}} \\ \mathbf{U}^{2^{i-1}} & -\mathbf{U}^{2^{i-1}} \end{pmatrix}$$

*end*
3. Initialize power matrix.
**Iteration**

(continued)

1.

$$\mathbf{X}_{\lim}^{S \cdot L,L}[lA] = \begin{pmatrix} \underline{\underline{\mathbf{X}}}_{S-1}^{L}[lA] \\ \vdots \\ \underline{\underline{\mathbf{X}}}_{1}^{L}[lA] \\ \underline{\underline{\mathbf{X}}}_{0}^{L}[lA] \end{pmatrix} + \begin{pmatrix} u_{S_u-1,l \bmod S_u} \cdot \mathbf{I}^L \\ \vdots \\ u_{S_u-S+1,l \bmod S_u} \cdot \mathbf{I}^L \\ u_{S_u-S,l \bmod S_u} \cdot \mathbf{I}^L \end{pmatrix}$$

2.

$$\mathbf{Q}^{S \cdot L,L}[lA] = \frac{1}{1-\gamma} \cdot \left(\mathbf{P}_{\alpha,\lim}^{S \cdot L}[(l-1)A]\right)^{-1} \cdot (\mathbf{X}_{\lim}^{S \cdot L,L}[lA])^{\bullet}$$

3.

$$\underline{\underline{\mathbf{D}}}^{L}[lA] = \frac{2\alpha L}{\gamma}\mathbf{I}^L + (\mathbf{X}_{\lim}^{S \cdot L,L}[lA])^{t} \cdot \mathbf{Q}^{S \cdot L,L}[lA]$$

4. Calculate $(\underline{\mathbf{D}}^{L}[lA])^{-1}$

5.

$$(\mathbf{P}_{\alpha,\lim}^{S \cdot L}[lA])^{-1} = \frac{1}{1-\gamma}(\mathbf{P}_{\alpha,\lim}^{S \cdot L}[(l-1)A])^{-1}$$
$$- \mathbf{Q}^{S \cdot L,l}[lA] \cdot (\underline{\underline{\mathbf{D}}}^{L}[lA])^{-1} \cdot (\mathbf{Q}^{S \cdot L,L}[lA])^{h}$$

Note that the inverse of $\mathbf{P}^{S \cdot L}[l4]$ is also a sparse matrix with the same structure and we define

$$(\mathbf{P}_{\alpha,\lim}^{S \cdot L})^{-1} = \begin{pmatrix} \underline{\underline{\mathbf{T}}}_{S-1,S-1}[lA] & \cdots & \underline{\underline{\mathbf{T}}}_{S-1,1}[lA] & \underline{\underline{\mathbf{T}}}_{0}^{L}[lA] \\ \vdots & \ddots & \vdots & \vdots \\ \underline{\underline{\mathbf{T}}}_{1,S-1}^{L}[lA] & \cdots & \underline{\underline{\mathbf{T}}}_{1,1}^{L}[lA] & \underline{\underline{\mathbf{T}}}_{1,0}^{L}[lA] \\ \underline{\underline{\mathbf{T}}}_{0,S-1}^{L}[lA] & \cdots & \underline{\underline{\mathbf{T}}}_{0,1}^{L}[lA] & \underline{\underline{\mathbf{T}}}_{0,0}^{L}[lA] \end{pmatrix}$$

where for $0 \le i < S$ and $0 \le j < S$

$$\underline{\underline{\mathbf{T}}}_{i,j}^{L}[lA] = diag\left\{\underline{T}_{i,j}^{L}[lA]\right\}.$$

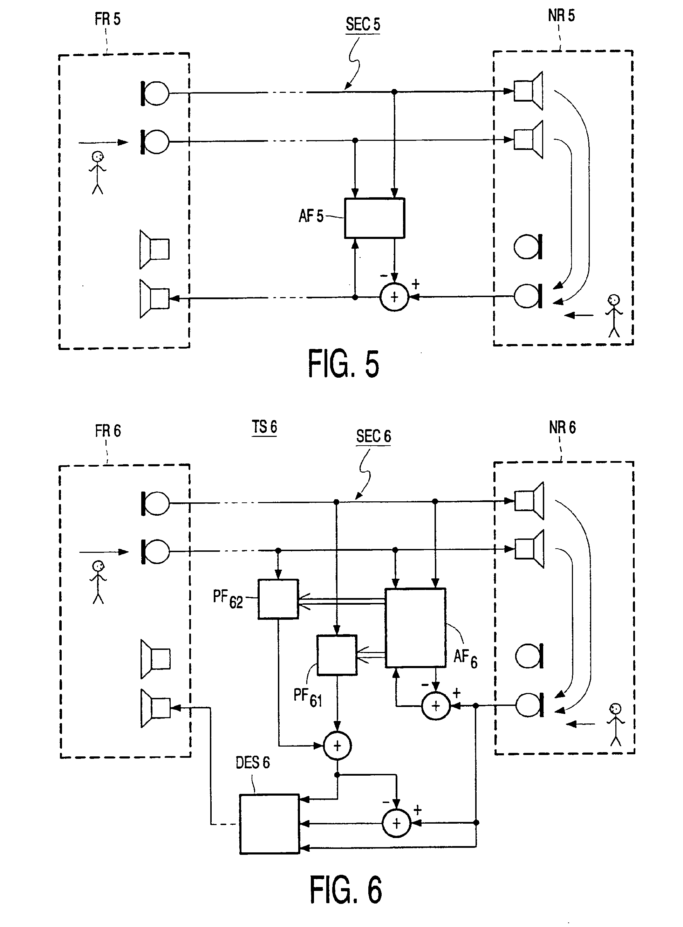

Figure 5 shows schematically an example of a teleconferencing system TS5 using a stereo echo canceller SEC5 with adaptive filters AF5 (only one shown). The teleconferencing system comprises a far room FR5 and a near room NR5. The adaptive filter AF5 has to filter the stereo echo signals.

Figure 6 shows an example of a stereo echo canceller SEC6 used in a teleconferencing system TS6. The stereo echo canceling has to be performed between the near room NR6 and the far room FR6. In this example also programmable filters PF61 and PF62 are used to improve the performance of echo canceling. Programmable filters are described in US-A-4,903,247.

Further also the output of the programmable filters is supplied to a dynamic echo suppressor DES6, which is coupled with an output to the output of the stereo echo canceller. Dynamic echo suppressors are described in WO-97-45995.

A full stereo communication requires four stereo AECs, two on the near end side and two on the far end side. In figure 6 only one of those echo cancellers is depicted. Note that on each side we can combine the input signal delay-lines, the FFTs and the multiplication by the inverse power matrix of the two echo cancellers, which implies that the relative extra computational complexity for removing the crosscorrelation is even further reduced. The performance of the AECs is further improved by adding Dynamic Echo Suppressors as shown.

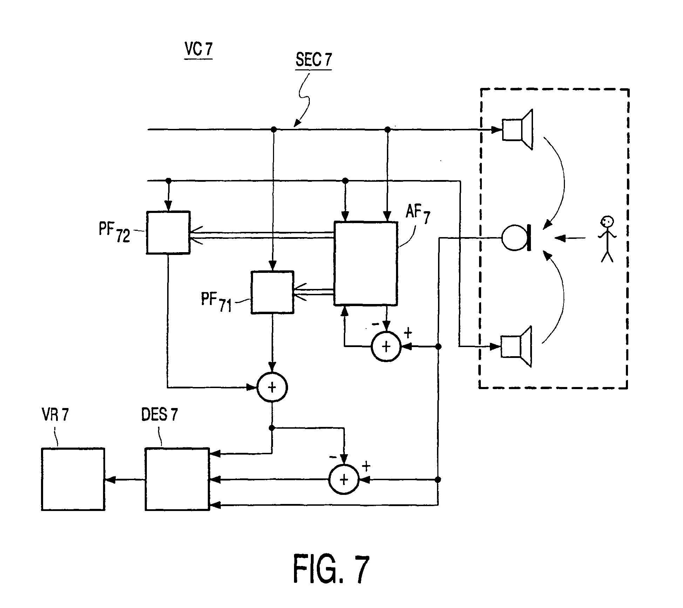

Figure 7 shows another application wherein a stereo echo canceller SEC7 is used in a voice controlled audio (and video) system VCS7. To be able to recognize the local speaker by a voice recognition engine we have to cancel the sound emitted by the audio set through the loudspeakers. This is done by using the stereo echo canceller SEC7. To improve the stereo echo canceling also in this example the programmable filters PF71 and PF72 are used, and the Dynamic Echo Suppresser DES7 is used. The output of the Dynamic Echo Suppressor is coupled to a voice recognizer VR7 for handling the filtered signal.

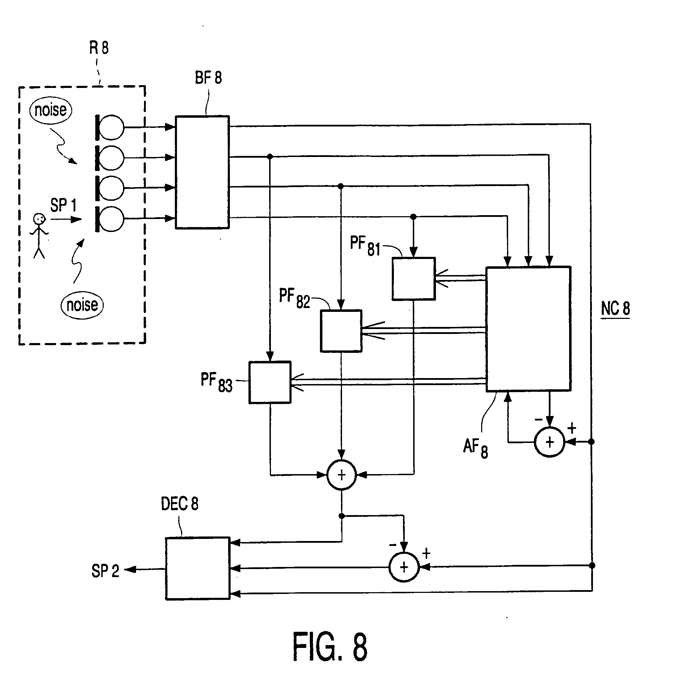

Figure 8 shows an example of a noise canceller NC8 for canceling the noise received on microphones in a room R8 together with a speech signal sp1 from a person in the room. In this example the microphones supply signals to a beam former BF8 which beam former supplies signals to the noise canceller NC8 and to programmable filters PF81, PF82 and PF83. Further the noise canceller comprises a dynamic echo suppressor DES8. The output of the Dynamic Echo Suppressor is coupled to the output of the noise suppressor to supply an estimate of the received speech sp2.

Also in the multiple input noise canceller we can apply a DES (which is in fact not suppressing an echo, but is similar to the DES in the AEC's case) and programmable filters to improve performance, as shown in figure 8. An extra problem is that the inputs of the filters may contain some elements of the desired signal ("signal leakage"), because the beamformer is not perfect. When the desired signal is speech signal, a speech detector can be used to improve the behaviour of the MFDAF.

Above some examples of application of a stereo echo canceller and of a noise canceller are described. It is to be noticed that the invention can be used in different applications and is not restricted to the described application, but only by the claims as appended below.

**Claims**

1. Adaptive filter (AF5) comprising at least two inputs for receiving at least two signals, and an output for supplying an output signal, wherein coefficient updates are determined in a transformed domain being a frequency domain and the filter comprises means to reduce an effect of a correlation between the input signals on the coefficient updates; **characterized in that** the means to reduce the effect of the correlation is arranged to reduce the effect of the correlation by multiplying frequency domain input signals with an inverse of an input channel's power matrix.

2. Adaptive filter (AF5) according to claim2, **characterized in that** the adaptive filter (AF5) comprises an update algorithm with transformed auto- and cross correlation matrices.

3. Adaptive filter (AF5) according to claim 1, **characterized by** comprising means for determining an input channel's power matrix by a first order recursive network, with a product of the frequency domain input signals and their conjugates as input, and further **characterized by** being arranged to at each iteration adding a certain positive value to all elements of a main diagonal.

4. Adaptive filter (AF5) according to claim 1, **characterized in that** the means to reduce the effect of the correlation comprises means for solving a linear set of equations with the input channel power matrix as an element of the linear set of equations.

5. Adaptive filter (AF5) according to claim 1, **characterized in that** the means to reduce the effect of the correlation is arranged to directly estimate the inverse of the input channel's power matrix , using a recursive update algorithm, and further **characterized in that** the means to reduce the effect of the correlation is arranged to impose a limit on the eigenvalues of the input channel's power matrix.

6. Signal processing device comprising the adaptive filter (AF5) according to claim 1.

7. Signal processing device according to claim 6, **characterized in that** the signal processing device further comprises a dynamic echo and noise suppressor as a post-processing device coupled to the output of the adaptive filter (AF5).

8. Signal processing device according to claim 6, **characterized in that** the signal-processing device comprises a programmable filter.

9.  Teleconferencing system comprising at least one signal-processing device according to claim 6.

10. Voice controlled electronic device comprising at least one signal-processing device according to claim 6.

11. Noise cancellation system comprising at least one signal-processing device according to claim 6.

12. Method for filtering at least two signals and for supplying an output signal wherein the method determines coefficient updates in a frequency domain and that the method reduces an effect of correlation between the input signals on the coefficient updates **characterized in that** the reduction of the effect of the correlation is achieved by multiplying frequency domain input signals with an inverse of an input channel's power matrix.

**Patentansprüche**

1.  Adaptivfilter (AF5) mit wenigstens zwei Eingängen zum Empfangen wenigstens zweier Signale, und mit einem Ausgang zum Liefern eines Ausgangssignals, wobei Koeffizientenaktualisierungen in einer transformierten Domäne, und zwar einer Frequenzdomäne, ermittelt werden, und das Filter Mittel aufweist zum Reduzieren eines Effektes einer Korrelation zwischen den Eingangssignalen auf die Koeffizientenaktualisierungen, **dadurch gekennzeichnet, dass** die Mittel zum Reduzieren des Effektes der Korrelation vorgesehen sind um den Effekt der Korrelation durch Multiplikation von Frequenzdomäneneingangssignalen mit einer Inverse einer Leistungsmatrix des Eingangskanals zu reduzieren.

2.  Adaptivfilter (AF5) nach Anspruch 2, **dadurch gekennzeichnet, dass** das Adaptivfilter (AF5) einen Aktualisierungsalgorithmus mit transformierten Auto- und Kreuzkorrelationsmatrizes umfasst.

3.  Adaptivfilter (AF5) nach Anspruch 1, **dadurch gekennzeichnet, dass** es Mittel aufweist zum Ermitteln einer Leistungsmatrix des Eingangskanals durch ein rekursives Netzwerk erster Ordnung, mit einem Produkt von Frequenzdomäneneingangssignalen und deren Ableitungen als Eingang, und weiterhin **dadurch gekennzeichnet, dass** es vorgesehen ist um bei jeder Wiederholung einen bestimmten positiven Wert zu allen Elementen einer Hauptdiagonalen hinzuzufügen.

4.  Adaptivfilter (AF) nach Anspruch 1, **dadurch gekennzeichnet, dass** die Mittel zum Reduzieren des Effektes der Korrelation Mittel aufweisen zum Lösen eines linearen Satzes von Gleichungen mit der Eingangskanalleistungsmatrix als Element des linearen Satzes von Gleichungen.

5.  Adaptivfilter (AF5) nach Anspruch 1, **dadurch gekennzeichnet, dass** die Mittel zum Reduzieren des Effekte der Korrelation dazu vorgesehen ist, unmittelbar die Inverse der Leistungsmatrix des Eingangskanals zu schätzen, und zwar unter Anwendung eines rekursiven Aktualisierungsalgorithmus, und weiterhin **dadurch gekennzeichnet, dass** die Mittel zum Reduzieren des Effektes der Korrelation dazu vorgesehen sind, den Eigenwerten der Leistungsmatrix des Eingangskanals eine Grenze aufzuerlegen.

6.  Signalverarbeitungsanordnung mit einem Adaptivfilter (AF5) nach Anspruch 1.

7.  Signalverarbeitungsanordnung nach Anspruch 6, **dadurch gekennzeichnet, dass** die Signalverarbeitungsanordnung weiterhin einen dynamischen Echo- und Rauschunterdrückungsanordnung als Nachbearbeitungsanordnung aufweist, die mit dem Ausgang des Adaptivfilters (AF5) gekoppelt ist.

8.  Signalverarbeitungsanordnung nach Anspruch 6, **dadurch gekennzeichnet, dass** die Signalverarbeitungsanordnung ein programmierbares Filter aufweist.

9.  Telekonferenzsystem mit wenigstens einer Signalverarbeitungsanordnung nach Anspruch 6.

10. Sprachgesteuerte elektronische Anordnung mit wenigstens einer Signalverarbeitungsanordnung nach Anspruch 6.

11. Rauschkompensationssystem mit wenigstens einer Signalverarbeitungsanordnung nach Anspruch 6.

**12.** Verfahren zum Filtern wenigstens zweier Signale und zum Liefern eines Ausgangssignals, wobei das Verfahren Koeffizientenaktualisierungen in einer Frequenzdomäne bestimmt und wobei das Verfahren einen Effekt der Korrelation zwischen den Eingangssignalen auf die Koeffizientenaktualisierungen reduziert, **dadurch gekennzeichnet, dass** die Reduktion des Effektes der Korrelation durch Multiplikation der Eingangssignale der Frequenzdomäne mit einer Inversen einer Leistungsmatrix des Eingangskanals erhalten wird.

**Revendications**

**1.** Filtre adaptatif (AF5) comprenant au moins deux entrées pour recevoir au moins deux signaux, et une sortie pour délivrer un signal de sortie, des mises à jour de coefficients étant déterminées dans un domaine transformé qui est un domaine des fréquences et le filtre comprenant un moyen pour réduire un effet d'une corrélation entre les signaux d'entrée sur les mises à jour des coefficients ; **caractérisé en ce que** le moyen permettant de réduire l'effet de la corrélation est conçu pour réduire l'effet de la corrélation en multipliant des signaux d'entrée dans le domaine des fréquences par une inverse de la matrice de puissance d'un canal d'entrée.

**2.** Filtre adaptatif (AF5) selon la revendication 2, **caractérisé en ce que** le filtre adaptatif (AF5) comprend un algorithme de mise à jour avec des matrices d'auto- et d'inter-corrélation transformées.

**3.** Filtre adaptatif (AF5) selon la revendication 1, **caractérisé en ce qu'**il comprend un moyen pour déterminer la matrice de puissance d'un canal d'entrée par un réseau récursif du premier ordre, avec en entrée un produit des signaux d'entrée dans le domaine des fréquences par leurs conjuguées, et **caractérisé en outre en ce qu'**il est conçu pour additionner, lors de chaque itération, une certaine valeur positive à tous les éléments d'une diagonale principale.

**4.** Filtre adaptatif (AF5) selon la revendication 1, **caractérisé en ce que** le moyen permettant de réduire l'effet de la corrélation comprend un moyen pour résoudre un système d'équations linéaires, la matrice de puissance du canal d'entrée étant un élément du système d'équations linéaires.

**5.** Filtre adaptatif (AF5) selon la revendication 1, **caractérisé en ce que** le moyen permettant de réduire l'effet de la corrélation est conçu pour estimer directement l'inverse de la matrice de puissance du canal d'entrée, en utilisant un algorithme de mise à jour récursif, et **caractérisé en outre en ce que** le moyen permettant de réduire l'effet de la corrélation est conçu pour imposer une limite aux valeurs propres de la matrice de puissance du canal d'entrée.

**6.** Dispositif de traitement du signal comprenant le filtre adaptatif (AF5) selon la revendication 1.

**7.** Dispositif de traitement du signal selon la revendication 6, **caractérisé en ce que** le dispositif de traitement du signal comprend en outre un suppresseur d'écho et de bruit dynamique en tant que dispositif de post-traitement relié à la sortie du filtre adaptatif (AF5).

**8.** Dispositif de traitement du signal selon la revendication 6, **caractérisé en ce que** le dispositif de traitement du signal comprend un filtre programmable.

**9.** Système de téléconférence comprenant au moins un dispositif de traitement du signal selon la revendication 6.

**10.** Dispositif électronique à commande vocale comprenant au moins un dispositif de traitement du signal selon la revendication 6.

**11.** Système d'annulation du bruit comprenant au moins un dispositif de traitement du signal selon la revendication 6.

**12.** Procédé pour filtrer au moins deux signaux et pour délivrer un signal de sortie, le procédé déterminant des mises à jour de coefficients dans un domaine de fréquences et le procédé réduisant un effet de la corrélation entre les signaux d'entrée sur les mises à jour des coefficients, **caractérisé en ce que** la réduction de l'effet de la corrélation peut être obtenue en multipliant des signaux d'entrée dans le domaine des fréquences par une inverse de la matrice de puissance d'un canal d'entrée.

FIG. 1

FIG. 2

FIG. 3

FIG. 4

FIG. 5

FIG. 6

FIG. 7

FIG. 8

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5828756 A
- US 4903247 A

- WO 9745995 A

**Non-patent literature cited in the description**

- **YUAN-HWANG CHEN et al.** Frequency Domain Implementation of Griffiths-Jim Adaptive Beamformer. *Journal of the Acoustical Society of America, USA, American Institute of Physics,* 01 June 1992, vol. 91 (6), 3354-3366

- **G.P.M. EGELMEERS.** Real time realization of large adaptive filters. Ph.D. thesis, Eindhoven University of Technology, November 1995